Europäisches Patentamt

European Patent Office

Office européen des brevets

(11) Publication number: **0 049 462**
**A2**

## (12) EUROPEAN PATENT APPLICATION

(21) Application number: **81107735.3**

(22) Date of filing: **29.09.81**

(51) Int. Cl.³: **G 11 C 11/00**

(30) Priority: **03.10.80 JP 138487/80**

(43) Date of publication of application:
**14.04.82 Bulletin 82/15**

(84) Designated Contracting States:
**AT BE CH DE FR GB IT LI NL SE**

(71) Applicant: **OLYMPUS OPTICAL CO., LTD.**
**43-2, 2-chome, Hatagaya Shibuya-ku**
**Tokyo(JP)**

(72) Inventor: **Tanikawa, Kowji**
**5-16-1, Sanda-cho Hachioji-shi**
**Tokyo(JP)**

(74) Representative: **Fleuchaus, Leo, Dipl.-Ing. et al,**
**Fleuchaus & Wehser Melchiorstrasse 42**
**D-8000 München 71(DE)**

(54) Memory device.

(57) A memory device, which comprises a capacitor (20) connected to a power supply terminal (10) through a main switch (12) to be used as a data holding power source and also connected to a read write memory (24). The memory device further comprises a comparator (22) which compares the level of the terminal voltage of the capacitor (20) with a minimum level of the data holding voltage of the memory (24) and a transistor (16) which is connected between the main switch (12) and capacitor (20) and rendered conducting in accordance with an output signal from the comparator (22).

FIG. 1

- 1 -

## Memory device

This invention relates to a memory device which still continues to store data even when a main power source is cut off.

Recently, a microprocessor is applied to various forms of control, for example, the control of a coller temperature or the automatic selection of a television channel. With such control devices, a read write memory should store data denoting the condition in which control is to be carried out. Further recently, where a patient is diagnosed from photographs of his coeliac cavity taken by means of an endoscope, the general practice comprises impressing data denoting the patient's name, the name of this affected section, the kind of an endoscope used, etc. on the above-mentioned coeliac photograph. Since it involves troublesome work to select such data, each time a film frame is photographed, it is necessary to store required data in advance in the read write memory. This read write memory is a volatile type, and consequently some measure must be taken against the sudden cutoff of a power source. The conventional measure (the so-called backup process) is to provide an auxiliary power source (cell or capacitor) in addition to a main power source and connect the auxiliary power source to the memory exclusively for sustenance of data, thereby preventing the contents of the memory

- 2 -

from being erased, should the main power source be cut off. However, the period during which the backup can be effected by the auxiliary power source is limited. Upon lapse of the period, the contents of the memory will disappear. Further even during the backup period, the contents of the memory sometimes are altered by intrusion of noise signals. Where the contents of the memory are thus changed or extinguished, then the object device is erroneously controlled, and consequently data impressed on a patient's coeliac photograph is rendered unreliable. Depending on the object device, the memory control gives rise to an unexpected accident. Where the device is controlled by a central processing unit (hereinafter abbreviated as CPU), the disappear of the contents of the memory will lead to the excursion of the CPU.

It is accordingly an object of this invention to provide a memory device which is saved from a malfunction caused by the extinction of stored data resulting from voltage drop occurring in an auxiliary power source applied exclusively for sustenance of data.

To attain the above-mentioned object, this invention provides a memory device which comprises a volatile read write memory, a power source for always impressing a voltage on the read write memory, and a judgment circuit which compares the level of a power source voltage with a prescribed voltage level, and, when the power source voltage has a lower level than the prescribed voltage level, then issues a detection signal.

This invention can be more fully understood from the following detailed description when taken in conjunction with the accompanying drawings, in which:

Fig. 1 is a circuit block diagram of an embodiment of a memory device according to the invention; and

Fig. 2 is a circuit diagram of the main section of another embodiment of a memory device according to the invention.

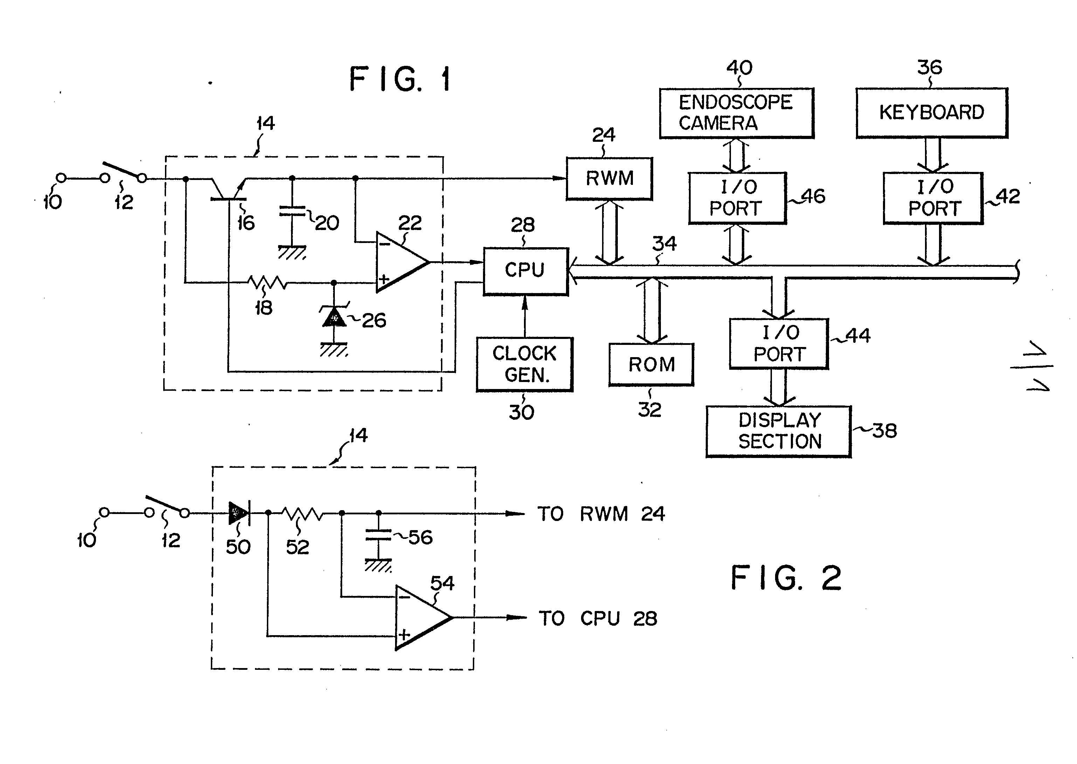

Description is now given with the accompanying drawing of a memory device according to one embodiment of this invention. Hereinafter, reference is made to the case where the subject memory device is applied to an endoscope photographic system provided with a mechanism for impressing photographic data on a patient's coeliac photograph. Referring to Fig. 1, a power supply terminal 10 is connected to a data holding power source 14 through a switch 12. This swtich 12 is connected to a collector of an NPN type transistor 16 and one end of a resistor 18. An emitter of the transistor 16 is grounded through a capacitor 20, and is connected to an inverting input terminal of a comparator 22 and a power supply terminal of a read write memory (abbreviated as RWM) 24. The other end of the resistor 18 is connected to a noninverting input terminal of the comparator 22 and a cathode of a Zener diode 26. An anode of the Zener diode 26 is grounded. An output terminal of the comparator 22 is connected to a CPU 28, whose output terminal is connected to a base of the transistor 16. A clock signal generator 30 for sending forth a timing signal necessary for the operation of the CPU 28 is also connected to the CPU 28. The CPU 28 controls the operation of the whole system including a mechanism for impressing the photographic data together on a patient's coeliac photograph. A nonvolatile read only memory (abbreriated as ROM) 32 for storing a control program is connected to the CPU 28 through a bus line 34. The RWM 24 is used to temporarily store data required for the excution of the control program. A keyboard 36 for setting data, display section 38 for giving an alarm and endoscope camera 40 whose operation is to be controlled are connected to the bus line 34 through the corresponding input/output (abbreviated as I/O) ports 42, 44 and 46.

Description is now given of the endoscope photographic system. The endoscope camara 40 photographs not only a patient's coeliac cavity, but also photographic data such as the patient's name, the name of the affected portion of his coeliac cavity and the kind of an endoscope applied. If those data are selected, each time a film frame is photographed, then photographing will have to be suspended during the period in which fresh data is supplied by operating the keyboard 36. This event is undesired, because a patient into whose coeliac cavity an endoscope is inserted will suffer increased pain. It is therefore preferred that all the required photographic data be stored in the RWN 24 by operating the keyboard 36, before the first film frame is photographed. With an endoscope photographic system, the main power source is generally set in the light source section and is so arranged as to supply power to the camera only when the camera is connected to the endoscope body. Namely, where the camera is connected to the endoscope, then the switch 12 is closed. At this time, the noninverting input terminal of the comparator 22 is impressed with a given reference voltage defined jointly by the power supply terminal 10, resistor 18 and Zener diode 26. This reference voltage is set at a level slightly higher than a minimum level of data holding voltage impressed on the RWM 24. Where, in this case, the terminal voltage of the capacitor 20 is higher than the reference voltage, then the RWM 24 is rendered capable of holding data. Upon receipt of a low level output signal from the comparator 22, the CPU 28 judges that the RWM 24 holdes data in a normal state. At this time, the CPU 28 supplies a low level control signal to the base of the transistor 16, thereby preventing the capacitor 20 from being more charged. After a prescribed period of time, the capacitor 20 is discharged. Where the terminal voltage of the capacitor 20 drops to a lower level than the reference voltage, then the comparator 22 issues a high level signal. Therefore, the CPU 28 supplies a high level control signal to the base of the transistor 16, which in turn is rendered conducting to cause the capacitor 20 to be charged again. Leter, the abovementioned operation cycle is repeated. Where the switch 12 is closed, namely, where the camera 40 is connected to the endoscope, then data stored in the RWM 24 is retained. Further, data of a film sensitivity, an F number and a charged condition of an electronic flash are stored in the RWM 24. Where a release button (not shown) is depressed, then the CPU 28 controls the steps of actuating the camera shutter and winding up a film.

Depending on a coeliac spot to be photographed, it is sometimes necessary to replace an endoscope by a different type. In such case, the switch 12 is left open. Where, the exchange of an endoscope is finished in a short time, no problem is raised. Where, however, the exchange consumes a long time, and the capacitor 20 is discharged to a greater extent, causing the level of the terminal voltage of the capacitor 20 to fall from that of the reference voltage, then the comparator 22 issues a high level signal. Even where the resultant high level control signal is supplied from the CPU 28 to the base of the transistor 16, the capacitor 20 is not charged, causing data to be extinguished from the RWM 24. If, in this case, an endoscope is exchanged for a different type, a camera is fitted to the exchanged different type of endoscope, and the shutter is actuated in disregard of the above-mentioned situation, then wrong data is likely to be photographed on a patient's coeliac photograph. With the memory device embodying this invention, where the switch 12 is closed, and the comparator 22 sends forth a high level signal, then the CPU 28 judges that an abnormal condition has happened, and instructs the display section 38 to indicate that data stored in the RWM 24 has been extinguished. The CPU 28 further supplies a high level control signal to the base of the transistor 16, causing the capacitor 20 to be freshly charged. Before the subsequent operation is carried out, fresh data is stored in the RWM 24 by operating the keyboard 36. This arrangement prevents the CPU 28 from controlling photographing and instructing the impression of photographic data by mistake.

To cope with the situation where the release button is later depressed by mistake, the CPU 28 converts exposure data and photographic data into an extremely standardized form. Namely, the aperture opening is set at F8, the shutter time is set at 1/125 second, and all photographic data are indicated by five zeros as 00000. This procedure prevents the CPU 28 from undertaking a very wrong control. The abovementioned standardized data should obviously be replaced by fresh data supplied by the keyboard 36.

With the memory device embodying this invention, where a camera is connected to a main power source, the capacitor 20 is charged, enabling the RWM 24 to retain data. Where the camera is connected to the main power source after long cut off therefrom, then the terminal voltage of the capacitor 20 is detected to judge whether data has been extinguished from the RWM 24 or not. This procedure eliminates the malfunction of the endoscope photographic system.

Fig. 2 is a circuit diagram of the main section of a memory device according to a second embodiment of this invention. The parts of Fig. 2 the same as those of Fig. 1 are denoted by the same numerals, description thereof being omitted. The second embodiment is the same as the first embodiment in other respects than a data holding power source 14. With the second embodiment of Fig. 2 a power supply terminal 10 is connected to an anode of a diode 50 through a switch 12. The cathode of the diode 50 is connected to one terminal of a resistor 52 and a noninverting input terminal of a comparator 54. The other end of the resistor 52 is connected to an inverting input terminal of the comparator 54 and a power supply terminal of a RWM 24 and is grounded through a capacitor 56. An output terminal of the comparator 54 is connected to a CPU 28.

With the second embodiment, where the switch 12 is closed where a camera is connected to an endoscope, the capacitor 56 is always charged. Since, at this time, the capacitor 56 is in a saturated condition, current from the power source 10 does not run through the resistor 52 at all. Accordingly, the comparator 54 issues a low level signal.

A certain length of time after the switch 12 is opened, the capacitor 56 is discharged at a higher rate. Where the level of the terminal voltage of the capacitor 56 drops from a minimum level of the data holding voltage of the RWM 24, then data is extinguished from the RWM 24. Later where the switch 12 is closed again, the capacitor 56 is charged, causing current to run through the resistor 52. Since, in this case, a difference arises in the potentials at both ends of the resistsor 52, the comparator 54 issues a high level signal. Upon receipt of the high level signal, the CPU 28 judges that data has been extinguished from the RWM 24, and later carries out the same operation as in the first embodiment. The second embodiment differs from the first embodiment in that when the capacitor 56 is saturated, then it is judged that data has been hold in the RWM 24.

The foregoing description refers to the case where a capacitor was used as a data holding power source. However, the capacitor may be replaced by any of a primary cell, secondary cell, etc. In this case, extinction of data from the RWM 24 is judged from the terminal voltage of such cell.

Claims:

1.  A memory device which comprises:

volatile read write memory means (24);

power supply means (10) which is connected to said read write memory means (24) to always supply voltage to said read write memory means (24); and

characterized by further comprising

judgment means (14) which compares the level of a voltage supplied by said power supply means (10) and a prescribed voltage level, and, when the power supply voltage has a lower level than the prescribed voltage level, sends forth a detection signal.

2.  The memory device according to claim 1, which further comprises an alarm display section (38) energized by the detection signal from said judgment means.

3.  The memory device according to claim 1 or 2, wherein, upon receipt of a detection signal, data stored in said memory means (24) is converted into a prescribed data; and the prescribed voltage of the judgment means (22, 54) is chosen to have a higher level than a minimum level of a data holding voltage of said memory means (24).

4.  The memory device according to claim 3, wherein said judgment means (14) comprises, a main switch (12), one end of which is connected to the power supply terminal (10), a switching member (16) which is connected between the other end of the main switch (12) and the power supply terminal of said memory means (24), is normally left open and, upon receipt of the detection signal, is closed, a capacitor (20) connected between the junction of the switching member (16) and memory means (24) on one hand and the ground on the other, and a comparator (22) which compares the level of the terminal voltage of the capacitor (20) and the prescribed voltage level and issues the detection signal.

5. The memory device according to claim 3, wherein said judgment means (14) comprises a main switch (12), one end of which is connected to the power supply terminal (10), a current to voltage conversion element (52) which is connected between the other end of the main switch (12) and the power supply terminal of the memory means (24), a capacitor (56) connected between junction of the conversion element (52) and memory means (24) on one hand and the ground on the other, and a comparator (54) sending forth the detection signal in accordance with the level of the terminal voltage of the conversion element (52).

FIG. 1

FIG. 2

TO RWM 24

TO CPU 28

ENDOSCOPE CAMERA

KEYBOARD

RWM

I/O PORT

I/O PORT

CPU

CLOCK GEN.

ROM

I/O PORT

DISPLAY SECTION

0049462